# EUROPEAN PATENT APPLICATION

(11) **EP 3 608 962 A1**
(43) Date of publication of application: **12.02.2020**
(21) Application number: 19189836.0
(22) Date of filing: 02.08.2019
(51) Int. Cl.: H01L 27/146, H01L 31/0304, H01L 31/18

(54) **MESA TRENCH ETCH WITH STACKED SIDEWALL PASSIVATION**

(30) Priority: 07.08.2018 US 201816057191
(71) Applicant: Sensors Unlimited, Inc., Princeton, NJ 08540 (US)
(72) Inventor: ZHANG, Wei, Princeton, NJ New Jersey 08550 (US); EVANS, Michael J., Yardley, PA Pennsylvania 19067 (US); MALCHOW, Douglas Stewart, Lawrence, NJ New Jersey 08648 (US); BEREZNYCKY, Paul L., Princeton, NJ New Jersey 08540 (US); PAIK, Namwoong, Lawrenceville, NJ New Jersey 08648 (US)
(74) Representative: Dehns

(57) **Abstract**

A method of forming an array of photodiodes includes forming a cap layer (102) on a surface (104) of an absorption layer (106). The method includes forming a plurality of spaced apart pixel diffusion areas (116) in the cap layer (102). The method includes forming a mesa trench (124) with opposed sidewalls (126) through the cap layer (102), wherein the mesa trench (124) surrounds each of the pixel diffusion areas (116) separating the pixel diffusion areas (116) from one another. The method includes forming a sidewall passivation layer (128) over the sidewalls (126) of the mesa trench (124) and removing a portion of the sidewall passivation layer (128) to expose a respective contact (118) electrically connected to each of the pixel diffusion areas (116), but leaving the sidewalls (126) of the mesa trench covered with the sidewall passivation layer (128) wherein the contact (118) is open and uncovered for electrical connection.

## Description

### BACKGROUND OF THE INVENTION

### 1. Field of the Invention

The present disclosure relates to sensor arrays, and more particularly to pixel structures for two-dimensional arrays.

### 2. Description of Related Art

Traditional pixels made up of diodes (PN, PiN, Avalanche diodes, etc.), such as those used in photodiode arrays (PDAs), contribute to the dark current and capacitance of the overall PDA. Pixel dark current and capacitance are key factors in determining the pixel performance. Lower values tend to indicate better pixel performance which ultimately translates to better signal to noise ratios at the overall camera and system levels. Pixel dark current and capacitance are significant contributors to the overall camera level noise. The unit pixel design plays a significant role in defining these contributing parameters to system level noise. Cross-talk and modulation transfer function (MTF) are particularly challenging in fine pitch and low dark current detector arrays.

Conventional pixel designs have generally been considered satisfactory for their intended purpose. However, there is still a need in the art for improved designs. This disclosure provides a solution for this need.

### SUMMARY OF THE INVENTION

A method of forming an array of photodiodes includes forming a cap layer on a surface of an absorption layer. The method includes forming a plurality of spaced apart pixel diffusion areas in the cap layer, wherein each pixel diffusion area extends beyond the surface of the absorption layer and into the absorption layer to receive a charge generated from photons received through the absorption layer by the pixel diffusion area. The method includes forming a mesa trench with opposed sidewalls through the cap layer, wherein the mesa trench surrounds each of the pixel diffusion areas separating the pixel diffusion areas from one another. The method includes forming a sidewall passivation layer over the sidewalls of the mesa trench and removing a portion of the sidewall passivation layer to expose a respective contact electrically connected to each of the pixel diffusion areas, but leaving the sidewalls of the mesa trench covered with the sidewall passivation layer wherein the contact is open and uncovered for electrical connection.

The method can include forming the contacts electrically connected to the respective pixel diffusion areas so each contact passes through a passivation layer to make electrical contact with the respective pixel diffusion area. Forming the mesa trench can include forming the mesa trench completely or partially through the cap layer and completely through the absorption layer. Forming the mesa trench can include forming the mesa by dry etching followed by wet etching. Forming the sidewall passivation layer can include covering the contacts and the mesa sidewalls with the sidewall passivation layer, wherein removing the portion of the passivation layer includes covering the sidewall passivation layer with a patterned photoresist layer and removing portions of the sidewall passivation layer not protected by the photoresist layer. The method can include disposing the absorption layer on a buffer layer that is on a substrate layer on an opposite side of the absorption layer from the cap layer.

A photodiode array includes an absorption layer, a cap layer disposed on a surface of the absorption layer, and a plurality of pixel diffusion areas within the cap layer. Each of the pixel diffusion areas of the plurality of pixel diffusion areas extends beyond the surface of the absorption layer and into the absorption layer to receive a charge generated from photons received through the absorption layer by the respective pixel diffusion area. A mesa trench is defined through the cap layer surrounding each of the pixel diffusion areas in the plurality of pixel diffusion areas, wherein the mesa trench defines sidewalls. A sidewall passivation layer covers the sidewalls of the mesa trench. Openings through the sidewall passivation layer are included to leave open a contact for each pixel diffusion area in the plurality of pixel diffusion areas for electrical connection through the sidewall passivation layer.

The sidewall passivation layer can include multiple dielectric layers, configured to reduce dark current due to surface leakage and to reduce stress. The absorption layer can include a semiconductor material able to detect optical signals from a light source through wavelengths ranging from the visible region to the infrared region. A passivation layer can be disposed on a surface of the cap layer opposite from the absorption layer, wherein the passivation layer forms a portion of the side walls of the mesa trench. The contact for each of the pixel diffusion areas of the plurality of pixel diffusion areas can be disposed on the passivation layer and in electrical contact with the pixel diffusion area through an opening in the passivation layer. A portion of the contact can be sandwiched between the sidewall passivation layer and the passivation layer. The mesa can extend completely though the cap layer and completely through the absorption layer. A substrate layer can be included on a side of absorption layer opposite the cap layer. A buffer layer can be disposed between the absorption layer and the substrate layer. The cap layer can include InP and wherein the absorption layer includes InGaAs.

The sidewall passivation layer combined with a space gap of the mesa trench can reflect photons that hit the sidewall passivation layer back into the absorption layer within a desired wavelength range for increased quantum efficiency relative to if there were no sidewall passivation layer and space gap. The sidewalls can have an angle relative to one another, wherein the angle is tailored using inductive coupled plasma (ICP) design of experiment (DOE).

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Fig. 1 is a schematic cross-sectional view of an exemplary embodiment of a photodetector array constructed in accordance with the present disclosure, showing a planar structure before forming the pixel diffusion areas;
Fig. 2 is a schematic cross-sectional view of the photodetector array of Fig. 1, showing the pixel diffusion areas;
Fig. 3 is a schematic cross-sectional view of the photodetector array of Fig. 1, showing the metal contacts;
Fig. 4 is a schematic cross-sectional view of the photodetector array of Fig. 1, showing a photo resist layer;
Fig. 5 is a schematic cross-sectional view of the photodetector array of Fig. 1, showing the mesa trench isolating two pixels from each other;
Fig. 6 is a schematic cross-sectional view of the photodetector array of Fig. 1, showing the mesa trench after wet etching;
Fig. 7 is a schematic cross-sectional view of the photodetector array of Fig. 1, showing the sidewall passivation layer;
Fig. 8 is a schematic cross-sectional view of the photodetector array of Fig. 1, showing the sidewall passivation layer covering the sidewalls of the mesa trench with holes through the sidewall passivation for electrical connections for the contacts; and
Fig. 9 is a plan view of the photodetector array of Fig. 8, showing the mesa trench surrounding each pixel.

### DETAILED DESCRIPTION OF THE PREFERRED EMBODIMENTS

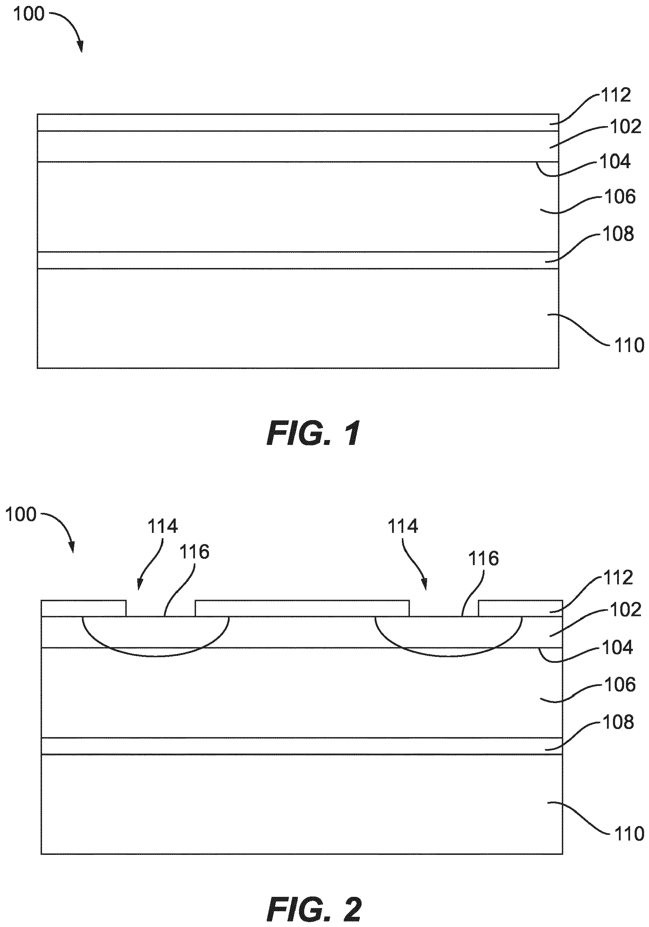

Reference will now be made to the drawings wherein like reference numerals identify similar structural features or aspects of the subject disclosure. For purposes of explanation and illustration, and not limitation, a partial view of an exemplary embodiment of a photodiode array in accordance with the disclosure is shown in Fig. 1 and is designated generally by reference character 100. Other embodiments of photodiode arrays in accordance with the disclosure, or aspects thereof, are provided in Figs. 2-9, as will be described. The systems and methods described herein can be used to isolate pixels from one another to reduce cross-talk and improve modulation transfer function (MTF) relative to conventional pixel configurations.

A method of forming an array of photodiodes 100 includes forming a cap layer 102 on a surface 104 of an absorption layer 106. The method can include disposing the absorption layer 106 on a buffer layer 108 that is on a substrate layer 110, e.g., an InP substrate, on an opposite side of the absorption layer 106 from the cap layer 102. A passivation layer 112 can be included on the cap layer 102 opposite from the absorption layer 106.

With reference now to Fig. 2, openings 114 can be formed in the passivation layer 112, e.g. using reactive ion etching (RIE) through a photolithography defined pattern, through which a plurality of spaced apart pixel diffusion areas 116 can be formed in the cap layer 102. Each pixel diffusion area 116 extends beyond the surface 104 of the absorption layer 106 and down into the absorption layer 106 (as oriented in Fig. 2) to receive a charge generated from photons received through the absorption layer 106 by the pixel diffusion area 116.

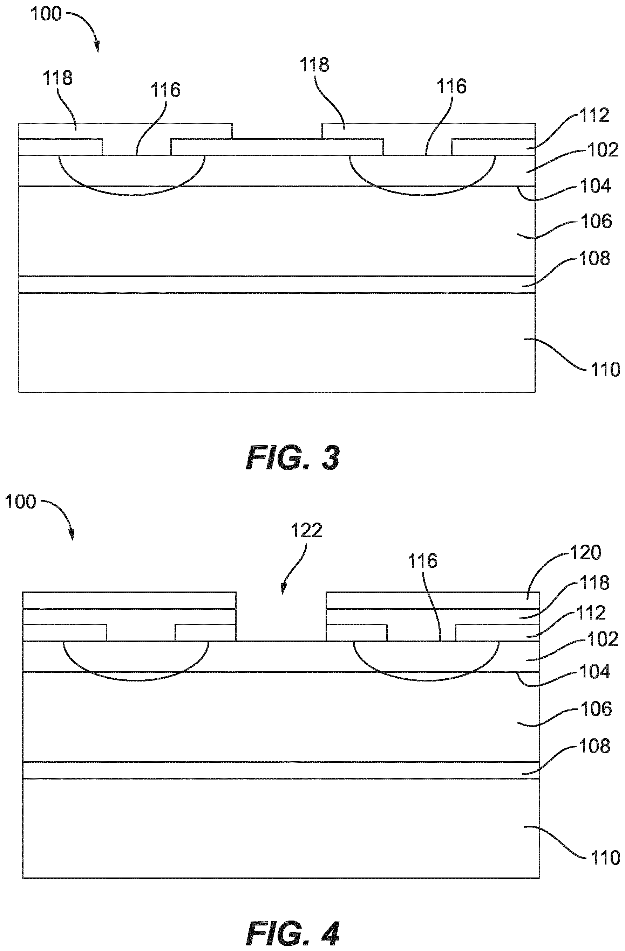

Referring now to Figs. 3-4, the method includes forming a respective metal contact 118 electrically connected to each respective pixel diffusion area 116 so each contact 118 makes electrical contact with the respective pixel diffusion area 116, e.g., using electron beam deposition (EBeam) patterned through lithography liftoff or lithography with inductive coupled plasma (ICP) dry etch and/or wet etch. The contacts 118 can be formed by depositing a layer of metal on the passivation layer 112 and cap layer 102 (in the state shown in Fig. 2), followed by using photo resist and metal etching and/or liftoff to remove the portions of the metal layer between the contacts 118.

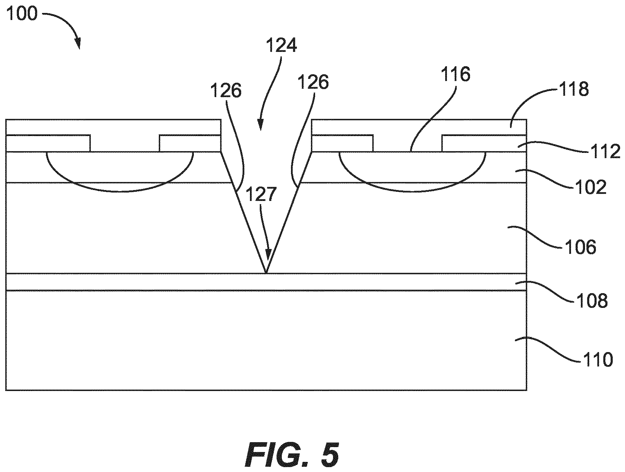

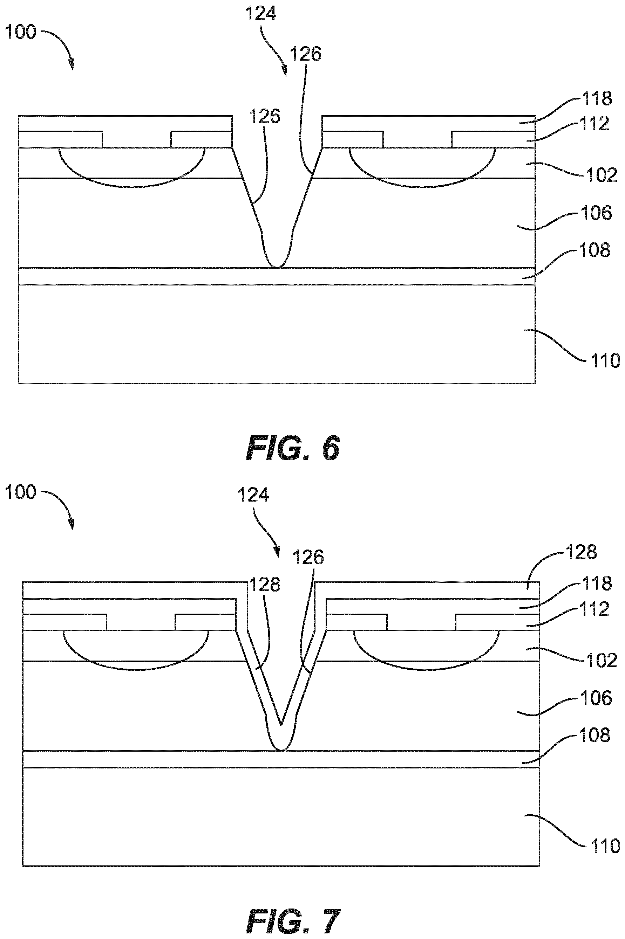

With reference now to Figs. 4-5, the method includes using a patterned layer of photo resist 120 with an opening 122 therein for forming a mesa trench 124 completely through the cap layer 102 and partially or completely through the absorption layer 106 surrounding each of the pixel diffusion areas 116 so that the mesa trench 124 defines opposed sidewalls 126. In cross-section as shown in Fig. 5, the sidewalls 126 meet at the bottom of the trench as a point 127. The metal of the contacts 118 can provide a mask for dry etching the mesa trench 124. After dry etching, e.g. using inductive coupled plasma (ICP) etching, the mesa trench can be further etched with a wet etching process to treat the sidewalls 126 as shown in Fig. 6. The wet treatment can be followed by a plasma clean process to clean and remove local oxidation to prepare the sidewalls 126 to receive sidewall passivation layers 128 shown in Fig. 7.

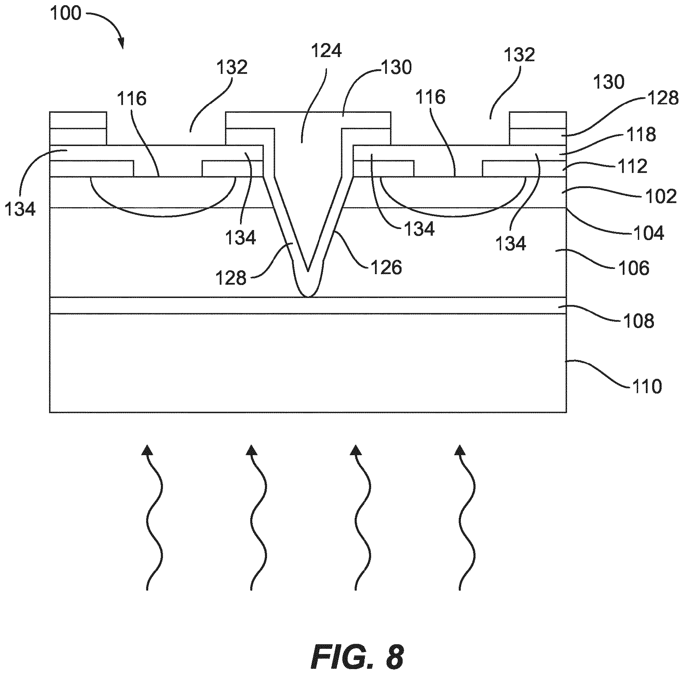

The method includes forming the sidewall passivation layer over the sidewalls 126 of the mesa trench 124 initially covering the contacts 118 and the mesa sidewalls 126 with the sidewall passivation layers 128. The sidewall passivation layers 128 can then be covered with a patterned photoresist layer 130 and portions of the sidewall passivation layers 128 not protected by the photoresist layer can be removed, e.g., using RIE and lithography, from a respective contact 118 electrically connected to each of the pixel diffusion areas 116. This leaves the sidewalls 126 of the mesa trench 124 covered with the sidewall passivation layers 128 but with the contacts 118 open and uncovered for electrical connection as shown in Fig. 8. The final photoresist layer 130 can ultimately be removed. The sidewall passivation layers 128 includes multiple dielectric layers, which can effectively reduce dark current due to surface leakage as well as reducing stress (which would otherwise be high for thick coatings, e.g., the sidewall passivation layers 128 together can be up to hundreds of nanometers thick, e.g., over 300 nm thick).

The resulting photodiode array 100 includes the absorption layer 106, the cap layer 102 disposed on the surface 104 of the absorption layer 106, and a plurality of pixel diffusion areas 116 within the cap layer 102. Each of the pixel diffusion areas 116 extends beyond the surface 104 of the absorption layer 106 and down into the absorption layer 106 (as oriented in Fig. 8) to receive a charge generated from photons (indicated with the large arrows in Fig. 8) received through the absorption layer 106 by the respective pixel diffusion area 116. The mesa trench 124 is defined through the cap layer 102 and through the absorption layer 106.

The sidewall passivation layers 128 combined with the space gap created by the mesa trench 124 can improve the reflection/absorbance characteristics of the absorption layer 106. The effective quantum efficiency (QE) of each pixel is increased relative to traditional pixel designs by reflecting photons that hit the sidewall passivation layers 128 back into the absorption layer 106 within a desired wavelength range. The sidewall passivation layers 128 includes multiple dielectric layers, which can effectively reduce dark current due to surface leakage as well as reducing stress (which would otherwise be high for thick coatings, e.g., the sidewall passivation layers 128 can be up to hundreds of nanometers thick, e.g., over 300 nm thick). The materials of the layers in the sidewall passivation layers 128 can be tailored to the desired wavelength. The processes disclosed herein can effectively isolate pixels from one another without exposing the absorption layer 106, which would otherwise result in increased leakage current. The angle of sidewalls 126 can be tailored using ICP DOE (design of experiment), which is beneficial for the subsequent sidewall passivation.

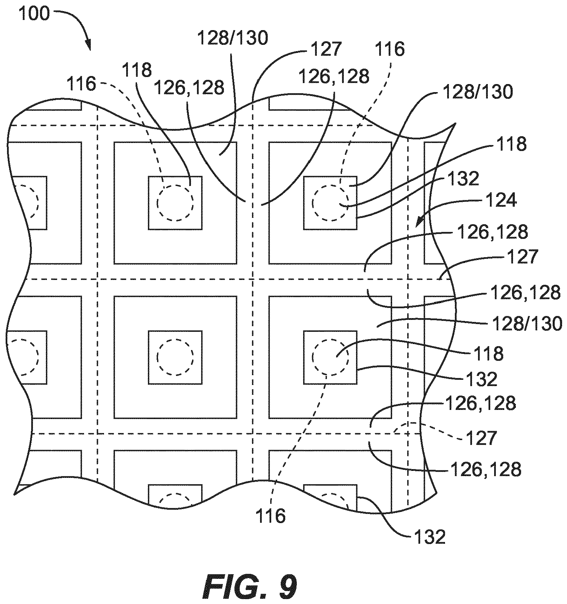

As shown in Fig. 9, the mesa trench 124 forms a grid that surrounds each of the pixel diffusion areas 116 the photodiode array, wherein the mesa trench 124 defines the sidewalls 126. The sidewall passivation layers 128 cover the sidewalls 126 of the mesa trench 124. Openings 132 through the sidewall passivation layers 128 are included to leave open each contact 118 for each pixel diffusion area 116 for electrical connection through the sidewall passivation layers 128. Those skilled in the art will readily appreciate that any suitable number and shape of pixels can be included without departing from the scope of this disclosure.

With reference again to Fig. 8, the absorption layer 106 can include a semiconductor material, e.g., InGaAs, that is able to detect optical signals from a light source through wavelengths ranging from the visible region to the infrared region. The passivation layer 128 forms a portion of the side walls 126 of the mesa trench 124, i.e. the portion of the sidewalls 126 above the cap layer 102 as oriented in Fig. 8. A portion 134 of the contact is sandwiched between the sidewall passivation layers 128 and the passivation layer 112.

The methods and systems of the present disclosure, as described above and shown in the drawings, provide for photodetector arrays with superior properties including reduced cross-talk and improved modulation transfer function (MTF) relative to conventional pixel configurations. While the apparatus and methods of the subject disclosure have been shown and described with reference to preferred embodiments, those skilled in the art will readily appreciate that changes and/or modifications may be made thereto without departing from the scope of the subject disclosure.

## Claims

1. A method of forming an array of photodiodes comprising:
forming a cap layer (102) on a surface (104) of an absorption layer (106);
forming a plurality of spaced apart pixel diffusion areas (116) in the cap layer (102), wherein each pixel diffusion area (116) extends beyond the surface (104) of the absorption layer (106) and into the absorption layer (106) to receive a charge generated from photons received through the absorption layer (106) by the pixel diffusion area (116);
forming a mesa trench (124) with opposed sidewalls (126) through the cap layer (102), wherein the mesa trench (124) surrounds each of the pixel diffusion areas (116) separating the pixel diffusion areas (116) from one another ;
forming a sidewall passivation layer (128) over the sidewalls (126) of the mesa trench (124); and
removing a portion of the sidewall passivation layer (128) to expose a respective contact (118) electrically connected to each of the pixel diffusion areas (116), but leaving the sidewalls (126) of the mesa trench (124) covered with the sidewall passivation layer (128) wherein the contact (118) is open and uncovered for electrical connection.

2. The method as recited in claim 1, further comprising forming the contacts (118) electrically connected to the respective pixel diffusion areas (116) so each contact (118) passes through a passivation layer (112) to make electrical contact with the respective pixel diffusion area (116).

3. The method as recited in claim 1 or 2, wherein forming the mesa trench (124) includes forming the mesa trench (124) completely through the cap layer (102) and partially or completely through the absorption layer (106).

4. The method as recited in claim 1, 2 or 3 wherein forming the mesa trench (124) includes forming the mesa by dry etching followed by wet etching.

5. The method as recited in any preceding claim, wherein forming the sidewall passivation layer (128) includes covering the contacts (118) and the mesa sidewalls (126) with the sidewall passivation layer (128), and wherein removing the portion of the sidewall passivation layer (128) includes covering the sidewall passivation layer (128) with a patterned photoresist layer (130) and removing portions of the sidewall passivation layer (128) not protected by the photoresist layer (130).

6. The method as recited in any preceding claim, further comprising disposing the absorption layer (106) on a buffer layer (108) that is on a substrate layer (110) on an opposite side of the absorption layer (106) from the cap layer (102).

7. A photodiode array comprising:
an absorption layer (106);
a cap layer (102) disposed on a surface (104) of the absorption layer (106);
a plurality of pixel diffusion areas (116) within the cap layer (102), each of the pixel diffusion areas (116) of the plurality of pixel diffusion areas (116) extending beyond the surface (104) of the absorption layer (106) and into the absorption layer (106) to receive a charge generated from photons received through the absorption layer (106) by the respective pixel diffusion area (116), wherein a mesa trench (124) is defined through the cap layer (107) surrounding each of the pixel diffusion areas (116) in the plurality of pixel diffusion areas (116), wherein the mesa trench (124) defines sidewalls (126); and
a sidewall passivation layer (128) that covers the sidewalls (126) of the mesa trench (124), wherein openings through the sidewall passivation layer (128) are included to leave open a contact (118) for each pixel diffusion area (116) in the plurality of pixel diffusion areas (116) for electrical connection.

8. The photodiode array as recited in claim 7, wherein the sidewall passivation layer (128) includes multiple dielectric layers, configured to reduce dark current due to surface leakage and to reduce stress.

9. The photodiode array as recited in claim 7 or 8, wherein the absorption layer (106) includes a semiconductor material able to detect optical signals from a light source through wavelengths ranging from the visible region to the infrared region.

10. The photodiode array as recited in claim 7, 8 or 9 further comprising a passivation layer (112) disposed on a surface of the cap layer (102) opposite from the absorption layer (106), wherein the passivation layer (112) forms a portion of the side walls (126) of the mesa trench (124).

11. The photodiode array as recited in claim 10, wherein the contact (118) for each of the pixel diffusion areas (116) of the plurality of pixel diffusion areas (116) is disposed on the passivation layer (112) and in electrical contact with the pixel diffusion area (116) through an opening in the passivation layer (112), preferably, wherein a portion of the contact (118) is sandwiched between the sidewall passivation layer (128) and the passivation layer (112).

12. The photodiode array as recited in any of claims 7-11, wherein the mesa (124) extends completely though the cap layer (102) and completely or partially through the absorption layer (106).

13. The photodiode array as recited in any of claims 7-12, further comprising a substrate layer (110) on a side of absorption layer (106) opposite the cap layer (120), optionally further comprising a buffer layer (108) disposed between the absorption layer (106) and the substrate layer (110).

14. The photodiode array as recited in any of claims 7-13, wherein:
the cap layer (102) includes InP and wherein the absorption layer (106) includes InGaAs; and/or
the sidewalls (126) have an angle relative to one another, wherein the angle is tailored using inductive coupled plasma (ICP) design of experiment (DOE).

15. The photodiode array as recited in any of claims 7-14, wherein the sidewall passivation layer (128) combined with a space gap of the mesa trench (124) reflects photons that hit the sidewall passivation layer (128) back into the absorption layer (106) within a desired wavelength range for increased quantum efficiency relative to if there were no sidewall passivation layer (128) and space gap.
